(19) Europäisches Patentamt
European Patent Office
Office européen des brevets

(11) **EP 3 557 621 A1**

(12) **EUROPEAN PATENT APPLICATION**

(43) Date of publication:
**23.10.2019 Bulletin 2019/43**

(51) Int Cl.:
***H01L 25/16*** (2006.01)

(21) Application number: **19168832.4**

(22) Date of filing: **12.04.2019**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **19.04.2018 US 201862660212 P
20.09.2018 CN 201811103069**

(71) Applicant: **InnoLux Corporation
Chu-Nan, Miao-Li 350 (TW)**

(72) Inventors:
- **Tseng, Ming-Chun
  350 Miao-Li County (TW)**
- **Mao, Li-Wei
  350 Miao-Li County (TW)**

(74) Representative: **Becker Kurig Straus
Patentanwälte
Bavariastrasse 7
80336 München (DE)**

(54) **OPTOELECTRONIC DEVICE**

(57) An electronic device (ED) includes a substrate (SUB), a plurality of thin film transistors (TFT) disposed on the surface of the substrate (SUB) and a plurality of light emitting diode elements (LE) arranged as an array on the substrate (SUB). The thin film transistors (TFT) include a source (T2), a gate (TI), a drain (T3) and a channel region (T4) respectively, wherein the channel region (T4) is positioned between the drain (T3) and the source (T2) in one thin film transistor (TFT) and has a channel length (L1) and a channel width (WI), and the channel width (WI) is greater than the channel length (L1). The light emitting diode elements (LE) are electrically connected to at least one of the thin film transistors (TFT) respectively and the thin film transistors (TFT) are used for being the driving elements (DT) of the electrically connected light emitting diode elements (LE).

FIG. 1

EP 3 557 621 A1

**Description**

Field of the Disclosure

The present disclosure relates to an electronic device, and more particularly to an electronic device including light emitting diodes (LED).

Background of the Disclosure

Light emitting diode (LED) element has the advantages of low power consumption, long device lifetime, and quick response speed. In addition, since the light emitting diode element also has the advantages of small size, vibration resistance, suitability for mass production, and ease of fabrication as a tiny device or an array device, it has been widely applied in information, communication, and consumer electronic products and various display devices. One of the research and development aspects for the manufacturer is to individually control the light emitting diode elements that are arranged in an array. However, this research faces a problem that it is difficult to provide a good arrangement when disposing the control elements and the small-sized light emitting diode elements while considering the arrangement density of the light emitting diode elements at the same time for not affecting the definition and luminance uniformity of the whole display device.

Summary of the Disclosure

This in mind, the present disclosure aims at providing an electronic device with a specific structure that can provide better illumination efficiency and better luminance uniformity.

As will be seen more clearly from the detailed description following below, an electronic device is provided by the present disclosure. In one embodiment, the electronic device which includes a substrate, a plurality of thin film transistors and a plurality of light emitting diode elements. The thin film transistors are disposed on a surface of the substrate. The thin film transistors respectively include a source, a gate, a drain, and a channel region, wherein the channel region is disposed between the drain and the source and has a channel length and a channel width, and the channel width is greater than the channel length. The plurality of light emitting diode elements are disposed on the substrate and arranged as an array, wherein the light emitting diode elements are respectively electrically connected to at least one of the thin film transistors, and thin film transistors serve as the driving elements of the electrically connected light emitting diodes.

These and other objectives of the present disclosure will no doubt become obvious to those of ordinary skill in the art after reading the following detailed description of the embodiment that is illustrated in the various figures and drawings.

Brief Description of the Drawings

In the following, the disclosure is further illustrated by way of example, taking reference to the accompanying drawings. Thereof:

FIG. 1 is a schematic top view of an electronic device of the present disclosure;
FIG. 2 is a partially enlarged schematic diagram of a light emitting diode element and driving circuits of an electronic device according to a first embodiment of the present disclosure;
FIG. 3 is a schematic cross-sectional view of a light emitting diode of the electronic device according to the first embodiment of the present disclosure;
FIG. 4 is a schematic circuit equivalent diagram of a driving circuit of the electronic device according to the first embodiment of the present disclosure;
FIG. 5 is a schematic partial top view of a thin film transistor of the electronic device according to the first embodiment of the present disclosure;
FIG. 6 is a schematic cross-sectional view of the electronic device applied as a backlight source according to the first embodiment of the present disclosure;
FIG. 7 to FIG. 9 are schematic cross-sectional views showing variant structures of the emitting diode element of the present disclosure;
FIG. 10 is a schematic top view of a further variant structure of the light emitting diode element of the present disclosure; and
FIG. 11 is an equivalent circuit diagram of an electronic device according to a second embodiment of the present disclosure.

Detailed Description

The present disclosure may be understood by reference to the following detailed description, taken in conjunction with the drawings as described below. It is noted that, for purposes of illustrative clarity and being easily understood by the readers, various drawings of this disclosure show a portion of the display device, and certain elements in various drawings may not be drawn to scale. In addition, the number and dimension of each device shown in drawings are only illustrative and are not intended to limit the scope of the present disclosure.

Certain terms are used throughout the description and following claims to refer to particular components. As one skilled in the art will understand, electronic equipment manufacturers may refer to a component by different names. This document does not intend to distinguish between components that differ in name but not function. When the terms "include", "comprise" and/or "have" are used in the description of the present disclosure, the corresponding features, areas, steps, operations and/or components would be pointed to existence, but not limited to the existence of one or a plurality of the corresponding or other features, areas, steps, operations and/or components. When the corresponding component such as layer or area is referred to "on another component (or the variant thereof)" or "extend to another component", it may be directly on another component or directly extend to another component, or other component may exist between them. On the other hand, when the component is referred to "directly on another component (or the variant thereof)" or "directly extend to another component", any component does not exist between them. In addition, when the component is referred to "be coupled to/with another component (or the variant thereof)", it may be directly connected to another component, or may be indirectly connected (such as electrically connected) to another component through other component or components.

It should be noted that the technical features in different embodiments described in the following can be replaced, recombined, or mixed with one another to constitute another embodiment without departing from the spirit of the present disclosure.

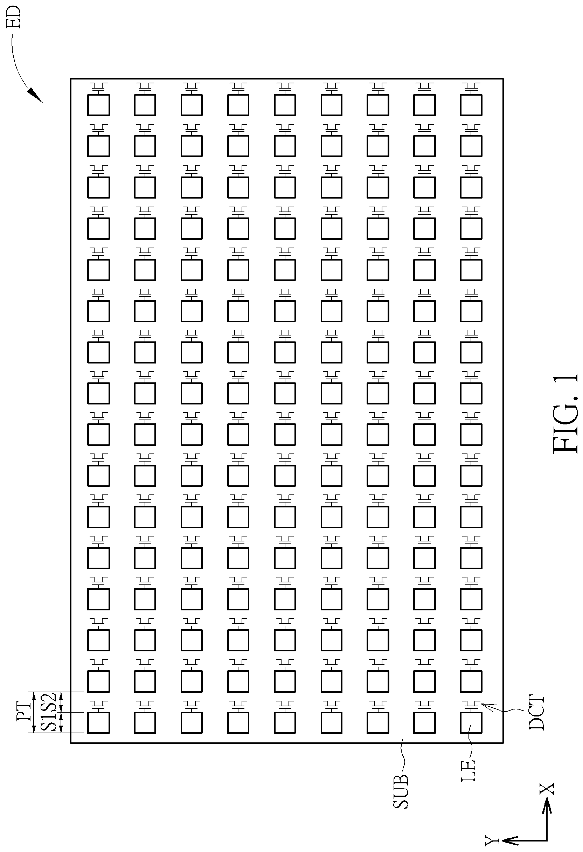

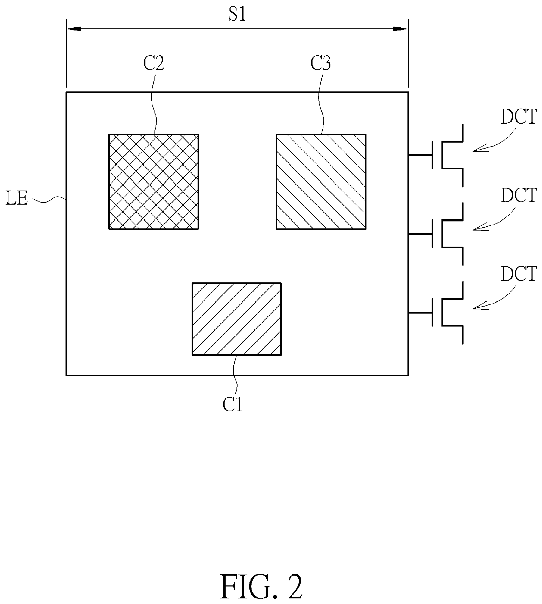

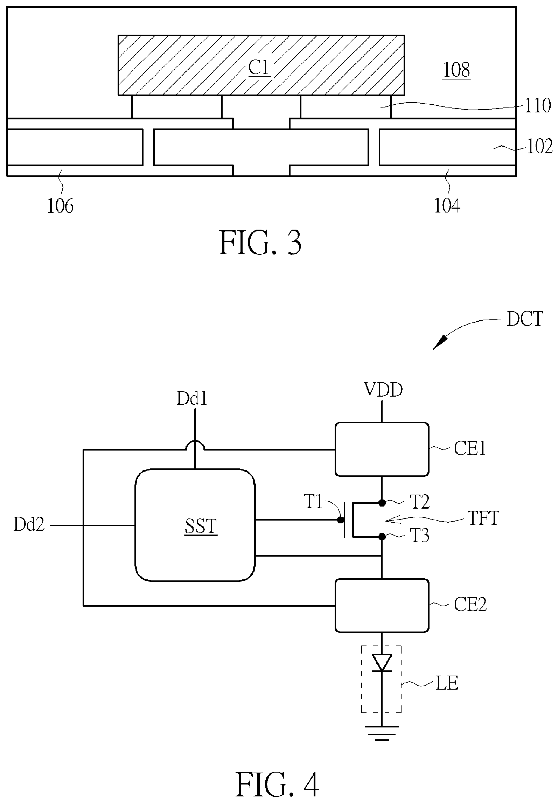

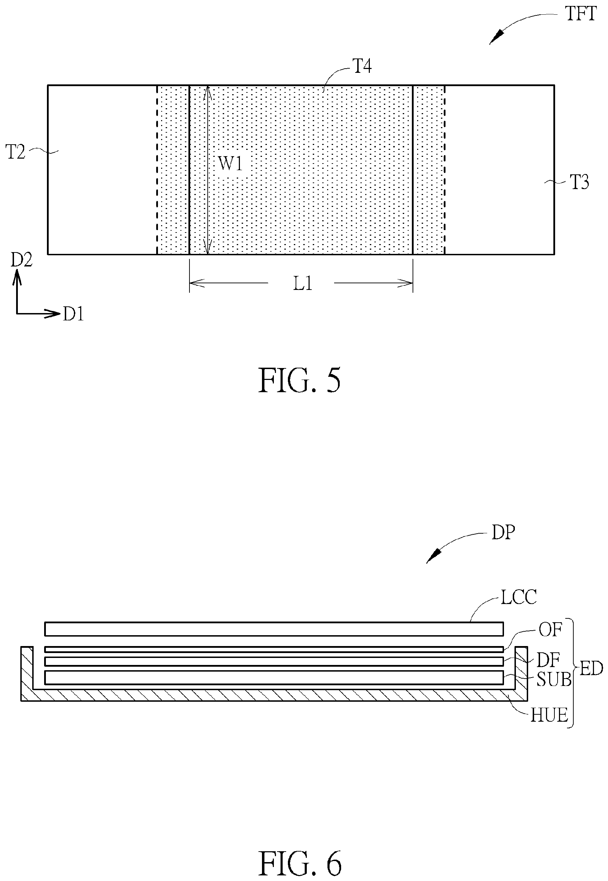

Referring to FIG. 1 to FIG. 6, FIG. 1 is a schematic top view of an electronic device of the present disclosure, FIG. 2 is a partially enlarged schematic diagram of a light emitting diode element and driving circuits of an electronic device according to a first embodiment of the present disclosure, FIG. 3 is a schematic cross-sectional view of a light emitting diode of the electronic device according to the first embodiment of the present disclosure, FIG. 4 is a schematic circuit equivalent diagram of a driving circuit of the electronic device according to the first embodiment of the present disclosure, FIG. 5 is a schematic partial top view of a thin film transistor of the electronic device according to the first embodiment of the present disclosure, and FIG. 6 is a schematic cross-sectional view of the electronic device applied as a backlight source according to the first embodiment of the present disclosure. As shown in FIG. 1, the present disclosure provides an electronic device ED which includes a substrate SUB, a plurality of driving circuits DCT and a plurality of light emitting diode elements LE. The substrate SUB may be any suitable solid substrate, such as a glass substrate, a quartz substrate and a sapphire substrate, or any flexible substrate such as including polyimide (PI) material, polycarbonate (PC) or polyethylene terephthalate (PET) material, but not limited thereto. In this embodiment, the light emitting diode elements LE respectively indicate a light emitting diode package that packages at least one LED chip, such as a mini light emitting diode (mini LED) with a package size such as from about 100 micrometers ($\mu$m) to about 1000$\mu$m, but not limited thereto. The above-mentioned package size indicates the size length S1 of the light emitting diode element LE in a direction (such as direction X). In this embodiment, the light emitting diode package indicates that an encapsulation adhesive is disposed at the light emitting side of the LED chip. The encapsulation adhesive may protect the LED chip or increase the light utility efficiency. In other embodiments, a light emitting diode element LE may be an unpackaged LED chip. In further other embodiments, a light emitting diode element LE may be a LED module including a silicon wafer as the carrier. The light emitting diode element LE may include one or more than two kinds of LED chips, as shown in FIG. 2, the light emitting diode element LE in this embodiment may include three LED chips C1, C2, C3 that can produce different color lights respectively, but the present disclosure is not limited thereto. In other embodiments, the light emitting diode element LE may only package one or two LED chips or package more LED chips, and the packaged LED chips may produce the same or different color lights. In this embodiment, for example, the LED chips C1, C2, C3 can produce red light, blue light and green light respectively, but not limited thereto. Referring to the schematic sectional view of the light emitting diode element LE shown in FIG. 3, only one LED chip C1 is illustrated in FIG. 3 for explanation. The light emitting diode element LE may include a package substrate 102, and the conductive line layers 104, 106 may be disposed on the surface and/or in the inner part of the package substrate 102. In this embodiment, the LED chips C1, C2, C3 are disposed on the package substrate 102 in a face-down way (conductive pad facing down) and may be electrically connected to the conductive line layers 104, 106 on the surface of the package substrate 102 through the connection pads 110, solder balls or other suitable materials. In addition, the light emitting diode elements LE may further include an encapsulation material 108 that covers the surfaces of the LED chip C1, C2, C3 and the package substrate 102. For example, the material of the encapsulation material 108 may include epoxy based resin or silicone, but not limited thereto. The light emitting diode elements LE used in the present disclosure are not limited to the structures illustrated in FIG. 2 and FIG. 3, any other suitable LED package structures may be applied to the present disclosure. Other types of LED package structures will be introduced to give examples in the variant embodiment hereinafter.

Referring back to FIG. 1 and FIG. 2, together with FIG. 4 and FIG. 5, the plurality of light emitting diode elements LE in this embodiment are disposed on the substrate SUB as an array and are electrically connected to the driving circuits DCT formed on the surface of the substrate SUB through the connection pads respectively. Each driving circuit DCT is formed on the surface of the substrate SUB and includes at least one thin film transistor TFT, and therefore the driving circuits DCT in FIG. 1 and FIG. 2 are represented as the symbols of thin film transistor. However, each driving circuit DCT may include more than one thin film transistor TFT and may include other electric elements, such as capacitor. One single light emitting diode element LE may be electrically connected to one or more driving circuits DCT. For example, one light emitting diode element LE shown in FIG. 2 is electrically connected to three driving circuits DCT as an example. Since each light emitting diode element LE is electrically connected to at least one thin film transistor TFT in the driving circuits DCT, the electronic device ED of this embodiment includes a plurality of thin film transistors TFT formed on the surface of the substrate SUB and the substrate SUB may be called as a thin film transistor substrate (TFT substrate) or an active substrate. In such design, the thin film transistors TFT serve as the driving elements of their electrically connected light emitting diode element LE respectively. In other words, the light emitting diode elements LE arranged as an array are driven by the electrically connected thin film transistors TFT respectively, so as to produce light at the same time or at different times when driven by the electrically connected thin film transistors TFT. In some embodiments, one thin film transistor TFT or one driving circuit DCT may be electrically connected two or more light emitting diode elements LE and can control the electrically connected plural light emitting diode elements LE at the same time. Furthermore, each light emitting diode element LE of this embodiment includes LED chips C1, C2, C3 that produces different color lights, thus the thin film transistors TFT can control the electrically connected light emitting diode elements LE to produce different color lights respectively, which means one thin film transistors TFT can control the different LED chips C1, C2, C3 to produce lights. With regard to the structure of the thin film transistors TFT, each thin film transistor TFT includes a gate T1, a source T2, a drain T3, a channel region T4 and a gate insulating layer formed by film layers respectively. For example, the gate T1, the source T2, and the drain T3 may respectively be composed of a metal layer such as including Mg, Ca, Al, Ag, W, Cu, Ni, Cr, Mo, Ti or alloys thereof or multi-layers of any of the above materials; and the channel region T4 may be formed of a semiconductor layer, such as including polysilicon, amorphous silicon, monocrystal silicon, oxide semiconductors or any other suitable semiconductor materials. In a first direction D1 parallel to the surface of the substrate SUB, at least a portion of the channel region T4 is disposed between the source T2 and the drain T3, and the smallest distance between the source T2 and the drain T3 is defined as the channel length L1 of the thin film transistor TFT in the first direction D1. In a second direction D2 perpendicular to the direction of the channel length L1 (i.e. the first direction D1), the length of the portion of the source T2 and the drain T3 overlapping the channel region T4 is defined as the channel width W1 of the thin film transistor TFT. According to the present disclosure, the ratio of the channel width W1 to the channel length L1 of the thin film transistor TFT is defined as a width-length ratio R, wherein the width-length ratio R is greater than 100%, i.e. the channel width W1 of each thin film transistor TFT of the present disclosure is greater than the corresponding channel length L1. The equation of the constant current of the thin film transistor TFT is as following:

$$Id = \tfrac{1}{2} Cox * u * (W/L) * (|Vgs| - |Vth|)^2 \;,$$

wherein "Id" indicates the drain current of the thin film transistor TFT, "Cox" indicates the transistor capacitance influenced by the condition of the oxide layer, "u" indicates the carrier mobility of the inversion layer, "Vgs" indicates the pressure drop across the gate and source (gate/source pressure drop), "Vth" indicates the threshold voltage, and "W/L" indicates the above-mentioned width-length ratio R of the thin film transistor TFT. Since the width-length ratio R of the thin film transistor TFT in the present disclosure is greater than 100%, a greater drain current Id can be obtained even though the gate/source pressure drop Vgs is not relatively great. In such situation, a drain/source pressure drop Vds of the thin film transistor TFT can be designed to have a less value, such as making the ratio value of the drain/source pressure drop Vds to the supply voltage VDD smaller. From the above, according to the present disclosure, the channel width W1 in the thin film transistor TFT is designed to be greater than the channel length L1 of the same thin film transistor TFT, so as to increase the whole performance and/or efficiency of the thin film transistor TFT. Accordingly, even though the gate/source pressure drop Vgs and the drain/source pressure drop Vds are both lower, a relatively greater drain current Id can still be provided, such that the electrically connected light emitting diode element LE can produce light with greater illumination.

According to this embodiment, each driving circuit DCT may selectively further include a signal storage element SST and one or more compensation element or compensation circuit disposed on the surface of the substrate SUB. The signal storage element SST may be a capacitor or other type of storage element and electrically connected to the gate T1 of one of the thin film transistors TFT. The signal storage elements SST can receive control signals or data signals through the conductive lines Dd1, Dd2. As an example, the driving circuit DCT of this embodiment may include the compensation elements CE1, CE2 electrically connected to the source T2 and the drain T3 of the thin film transistor TFT respectively, wherein the compensation elements CE1, CE2 may represent a compensation circuit respectively. The compensation elements CE1, CE2 can adjust the final output current and/or power of the thin film transistors TFT of the driving circuit DCT, so as to balance the currents and powers of the driving circuits DCT in different regions of the whole substrate SUB, and/or uniform the light emitting illuminations of different light emitting diode element LE. In some embodiments, different driving circuits DCT on the substrate SUB may have non-identical amounts of compensation elements/circuits or have compensation elements with non-identical circuit design, and these compensation elements/circuits may be electrically connected to the source T2 or drain T3 of the corresponding thin film transistor TFT or electrically connected to other elements of the driving circuits DCT respectively.

Referring to FIG. 1, each thin film transistor TFT of the present disclosure is disposed between two adjacent light emitting diode elements LE respectively. In the direction perpendicular to the surface of the substrate SUB, at least a portion of the thin film transistor TFT is exposed between two adjacent light emitting diode elements LE, i.e., the thin film transistors TFT are not totally covered or shielded by the two light emitting diode elements LE adjacent thereto in the direction perpendicular to the surface of the substrate SUB. In the direction X, the distance between two adjacent light emitting diode elements LE is defined as a spacing distance S2, the sum of the size length S1 of the light emitting diode elements LE in the direction X and the spacing distance S2 is defined as a pitch PT, and the size length S1 of the light emitting diode elements LE in the direction X is less than 0.9 times of the pitch PT. In some embodiments, the size length S1 of the light emitting diode elements LE in the direction X may further be greater than 0.1 times of the pitch PT. In some embodiments, the size length of the light emitting diode elements LE in another direction Y may also be less than 0.9 times of the pitch, but not limited thereto. The pitch PT of this embodiment may be in a range from about 0.1 millimeters (mm) to 10 mm, but not limited thereto. Based on the size and distance design of the above-mentioned pitch PT and size length S1, enough space may be existed between two adjacent light emitting diode elements LE for disposing one or more driving circuits DCT or disposing the thin film transistor(s) TFT with greater channel width W1, such that the width-length ratio R of the thin film transistor TFT in the driving circuit DCT can be greater than 100%, and therefore the thin film transistor TFT with higher efficiency can be disposed therein.

The electronic device ED of this embodiment can be used as a backlight source of non-self-luminous display device or non-self-luminous display panel. Referring to FIG. 6, for example, the electronic device ED may further include a diffuser DF and one or more optical film OF disposed on the substrate SUB, covering the light emitting diode elements LE on the surface of the substrate SUB. The electronic device ED may further include a housing HUE, wherein the substrate SUB is fixed in the housing HUE, and the diffuser DF and the optical film OF may be disposed inside the housing HUE or disposed above the housing HUE. Accordingly, the electronic device ED can be configured as a backlight module with more uniform luminance. When the electronic device ED is applied to the display device DP, it can be disposed at a light-incident side of the non-self-luminous display panel, such as disposed at the light-incident side of an liquid crystal display (LCD) panel LCC, so as to provide the backlight source to the LCD panel LCC for displaying images, but the present disclosure is not limited thereto. In some embodiments, the electronic device ED itself is a display device that can display images and an additional display panel disposed on the substrate SUB is not needed.

The electronic device of the present disclosure is not limited by the aforementioned embodiment, and may have other different embodiments and variant embodiments. To simplify the description, the identical components in each of the following embodiments and variant embodiments are marked with identical symbols. For making it easier to compare the difference between the embodiments and variant embodiments, the following description will detail the dissimilarities among different embodiments and variant embodiments and the identical features will not be redundantly described. In addition, the material and thickness of each film or layer and related fabrication process or conditions of the present disclosure may refer to the first embodiment, which will not be repeated.

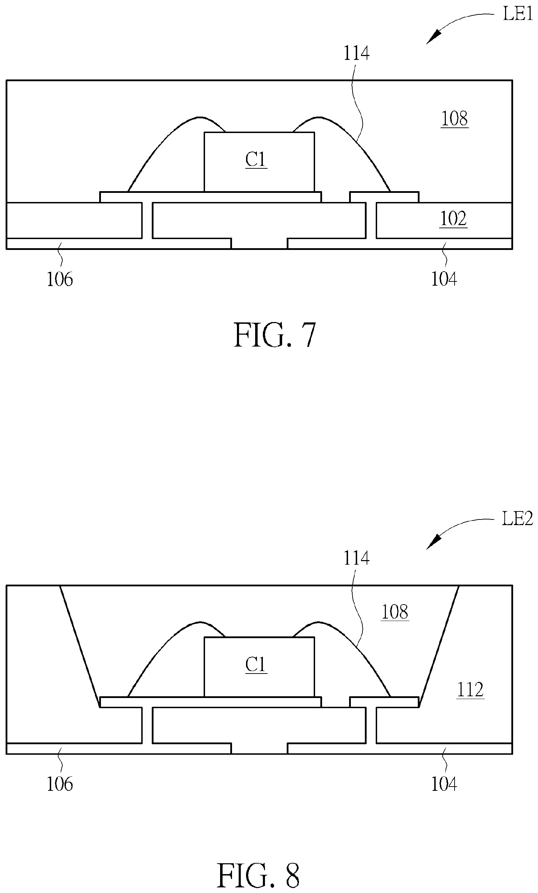

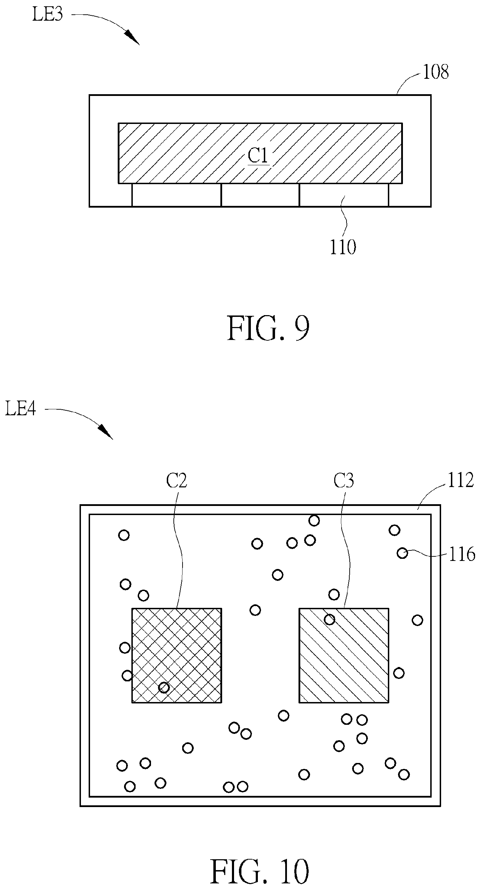

Referring to FIG. 7 to FIG. 10, FIG. 7 to FIG. 10 are schematic diagrams showing the variant structures of the emitting diode element LE. The structure of the light emitting diode elements LE used in the present disclosure is not limited to the structure shown in FIG. 2 and FIG. 3 and may have other package structures and/or have different amount of LED chips. Although FIG. 7 to FIG. 9 only illustrate one LED chip in the package structure for explanation, they are not intended to limit the actual packaged amount of LED chips. The light emitting diode element LE1 shown in FIG. 7 is mainly different from the structure in FIG. 3 in that the LED chip C1 of the light emitting diode element LE1 is disposed on the package substrate 102 in a face-up way (conductive pads facing up) and the conductive pads on the surface of the LED chip C1 may be electrically connected to the conductive line layers 104, 106 on the surface of the package substrate 102 respectively through the conductive lines 114. Referring to FIG. 8, the LED chip C1 in the light emitting diode element LE2 may be disposed in a cavity of a support frame 112 and is electrically connected to the conductive line layers 104, 106 disposed in the support frame 112 through the conductive lines 114. In addition, an encapsulation material 108 may be disposed in the cavity of the support frame 112 to cover and protect the LED chip C1. Referring to FIG. 9, the LED chip C1 is packaged in a face-down way (conductive pad facing down) and the encapsulation material 108 directly covers and surrounds the LED chip C1 to form the package structure, wherein the connection pads 110 are exposed by the encapsulation material 108 and no support frame or package substrate is needed. Referring to FIG. 10, a schematic top view of a further variant structure of the light emitting diode element is illustrated. The package structure of the light emitting diode element LE4 includes two LED chips C2, C3, wherein the LED chip C2 can produce blue light and the LED chip C3 can produce green light. The package structure of the light emitting diode element LE4 further includes phosphorus powder 116, such as red phosphorus powder. When the phosphorous powder 116 is illuminated by blue light or green light, it can transform a portion of the blue light or green light into red light. Therefore, the light emitting diode element LE4 can produce white light composed of the mixture of green light, blue light and red light. In another variant embodiment, the light emitting diode element of the present disclosure may package one single blue light LED chip and include yellow phosphorous powder in its package structure, such that the light emitting diode element can also produce white light eventually. In a further variant embodiment, the light emitting diode elements of the present disclosure may respectively package one single blue light LED chip and include quantum dots with different particle diameters in the package structure, such that the light emitting diode elements can produce various color lights eventually, i.e., different light emitting diode elements can produce different color lights resulted from the quantum dots with different particle diameters. In even another variant embodiment, the quantum dots may be disposed at the light-emitting sides of the light emitting diode elements of the present disclosure. All of the above-mentioned various types of package structures of light emitting diode elements or other suitable types of light emitting diode elements may be applied to each embodiment and variant embodiments of the present disclosure.

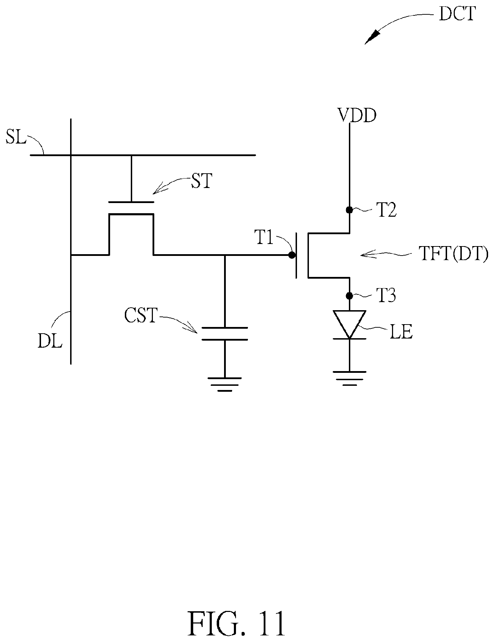

FIG. 11 is an equivalent circuit diagram of an electronic device according to a second embodiment of the present disclosure. Referring to FIG. 11 together with FIG. 1, in the second embodiment, the electronic device ED itself of the present disclosure is a display device. The light emitting diode elements LE are individually driven by the corresponding thin film transistors TFT to produce different color lights at different times, thus each light emitting diode element LE may serve as a light-emitting unit of a pixel or a sub-pixel of the display device. In such design, the electronic device ED may further include a plurality of data lines DL and a plurality of scan lines SL which cross to each other to define the pixels/sub-pixels and are respectively electrically connected to the thin film transistors TFT and light emitting diode elements LE in the pixels/sub-pixels. The driving circuit DCT of each sub-pixel may refer to FIG. 11. The driving circuit DCT may further include a switch element ST and a storage element CST (or called as signal storage element). For example, the switch element ST may be another thin film transistor with a gate electrically connected to the scan line SL, a source electrically connected to the data line DL, and a drain electrically connected to the storage element CST and the gate T1 of the thin film transistor TFT serving as the driving element DT. In other words, each switch element ST is electrically connected to one of the data lines DL, one of the scan lines SL and one of the light emitting diode elements LE respectively. The storage element CST may be a capacitor, for instance, and have one end being electrically connected to the switch element ST and the gate T1 of the thin film transistor TFT and another end being grounded. In this embodiment, the electronic device ED may further selectively include additional optical films, mask or protection plate disposed on the substrate SUB for protecting the light emitting diode elements LE and the driving circuits DCT formed on the substrate SUB.

From the above, the light emitting diode elements of the electronic device of the present disclosure are disposed on a TFT substrate and arranged as an array, each light emitting diode element is electrically connected to one or more TFT driving element, and the width-length ratio of the channel of the TFT driving elements is greater than 100%, so as to provide a good transistor efficiency. Accordingly, the light emitting diode elements may have good illumination efficiency even in a relatively low supply voltage. In another aspect, the pitch of the light emitting diode elements of the present disclosure is designed to have a specific proportion or scale, thus there are more space between adjacent light emitting diode elements for disposing the thin film transistors. Accordingly, the possibility of crushing the thin film transistors when bonding the light emitting diode elements onto the substrate may be reduced. The thin film transistors may have greater channel width because of the larger disposition space, such that the width-length ratio of channel may be increased.

For those skilled in the art, the technical features disclosed in the aforementioned embodiments can be replaced or recombined with one another to constitute another embodiment without departing from the spirit of the present disclosure.

**Claims**

1.   An electronic device (ED), **characterized by**:

    a substrate (SUB);
    a plurality of thin film transistors (TFT), disposed on a surface of the substrate (SUB), each of the thin film transistors (TFT) comprising a source (T2), a gate (T1), a drain (T3), and a channel region (T4), the channel region (T4) being disposed between the drain (T3) and the source (T2) and having a channel length (L1) and a channel width (W1), and the channel width (W1) being greater than the channel length (L1); and

a plurality of light emitting diode (LE, LE1, LE2, LE3, LE4) elements, disposed on the substrate (SUB) as an array, wherein each of the light emitting diode elements (LE, LE1, LE2, LE3, LE4) is electrically connected to at least one of the thin film transistors (TFT), and the thin film transistor (TFT) serves as a driving element (DT) for the light emitting diode element (LE, LE1, LE2, LE3, LE4) which is electrically connected by the thin film transistor (TFT).

2. The electronic device of claim 1, **characterized in that** one of the thin film transistors (TFT) is disposed between two adjacent light emitting diode elements (LE, LE1, LE2, LE3, LE4) of the light emitting diode elements (LE, LE1, LE2, LE3, LE4), and at least a portion of the thin film transistor (TFT) is exposed by the two adjacent light emitting diode elements (LE, LE1, LE2, LE3, LE4) therebetween in a direction perpendicular to the surface of the substrate (SUB).

3. The electronic device of claim 1 or claim 2, **characterized in that** a distance between the two adjacent light emitting diode elements (LE, LE1, LE2, LE3, LE4) in a direction is defined as a spacing distance (S2), a sum of a size length (S1) of one of the light emitting diode elements (LE, LE1, LE2, LE3, LE4) in the direction and the spacing distance (S2) is defined as a pitch (PT), and the size length (S1) of one of the light emitting diode elements (LE, LE1, LE2, LE3, LE4) in the direction is less than 0.9 times of the pitch (PT).

4. The electronic device of claim 3, **characterized in that** the size length (S1) of one of the light emitting diode elements (LE, LE1, LE2, LE3, LE4) in the direction is greater than 0.1 times of the pitch (PT).

5. The electronic device of claim 3, **characterized in that** the pitch (PT) is in a range from 0.1 millimeters (mm) to 10 mm.

6. The electronic device of any one of claim 1 to claim 5, **characterized in that** one of the light emitting diode elements (LE, LE1, LE2, LE3, LE4) is a light emitting diode package that includes at least one light emitting diode chip (C1, C2, C3).

7. The electronic device of claim 6, **characterized in that** one of the light emitting diode elements (LE, LE1, LE2, LE3, LE4) comprises an encapsulation adhesive (108) disposed at a light emitting side of the light emitting diode chip (C1, C2, C3).

8. The electronic device of any one of claim 1 to claim 7, **characterized in that** one of the light emitting diode elements (LE, LE1, LE2, LE3, LE4) comprises phosphorous powder (116) or quantum dots.

9. The electronic device of any one of claim 1 to claim 8, **characterized in that** each of the light emitting diode elements (LE, LE1, LE2, LE3, LE4) is driven by the electrically connected thin film transistor (TFT), such that the light emitting diode elements (LE, LE1, LE2, LE3, LE4) are capable of emitting lights at the same time or at different times when driving by the thin film transistors (TFT).

10. The electronic device of any one of claim 1 to claim 9, **characterized in that** the light emitting diode elements (LE, LE1, LE2, LE3, LE4) respectively include two or more light emitting diode chips (C1, C2, C3), and the thin film transistors (TFT) are capable of controlling the electrically connected light emitting diode elements (LE, LE1, LE2, LE3, LE4) to produce light with different colors respectively.

11. The electronic device of any one of claim 1 to claim 10, further **characterized by** a plurality of signal storage elements (SST) disposed on the surface of the substrate (SUB), one of the signal storage elements (SST) being respectively electrically connected to the gate (T1) of one of the thin film transistors (TFT).

12. The electronic device of any one of claim 1 to claim 11, further **characterized by** a plurality of compensation circuits (CE1, CE2) disposed on the surface of the substrate (SUB), one of the compensation circuits (CE1, CE2) being respectively electrically connected to the source (T2) or the drain (T3) of one of the thin film transistors (TFT).

13. The electronic device of any one of claim 1 to claim 12, further **characterized by** a plurality of switch elements (ST) disposed on the surface of the substrate (SUB), one of the switch elements (ST) being respectively electrically connected to the gate (T1) of one of the thin film transistors (TFT).

14. The electronic device of any one of claim 1 to claim 13, further **characterized by** a display panel (LCC) disposed at a side of the substrate (SUB), wherein the light emitting diode elements (LE, LE1, LE2, LE3, LE4) serve as a backlight source of the display panel (LCC).

15. The electronic device of any one of claim 1 to claim 14, **characterized in that** the light emitting diode elements (LE, LE1, LE2, LE3, LE4) are mini LED packages with a package size in a range from 100 micrometers ($\mu$m) to 1000 $\mu$m.

FIG. 1

FIG. 2

FIG. 3

FIG. 4

FIG. 5

FIG. 6

LE1

114

108

C1

102

106

104

FIG. 7

LE2

114

108

C1

112

106

104

FIG. 8

LE3

108

C1

110

## FIG. 9

LE4

C2    C3    112

116

## FIG. 10

FIG. 11

Europäisches
Patentamt

European
Patent Office

Office européen
des brevets

# EUROPEAN SEARCH REPORT

Application Number

EP 19 16 8832

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/268239 A1 (SHEN WULIN [CN] ET AL) 15 September 2016 (2016-09-15) | 1-5,9-15 | INV. H01L25/16 |
| A | * paragraphs [0040] - [0081] * | 6-8 | |
| X | US 2017/358505 A1 (CHANG CHIA-HSIUNG [TW] ET AL) 14 December 2017 (2017-12-14) | 1,5-8,15 | |
| A | * paragraphs [0028] - [0083]; figures 16,17a * | 2-4,9-14 | |

**TECHNICAL FIELDS SEARCHED (IPC)**

H01L

The present search report has been drawn up for all claims

| Place of search | Date of completion of the search | Examiner |
|---|---|---|
| The Hague | 15 July 2019 | Simeonov, Dobri |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

..................................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 19 16 8832

This annex lists the patent family members relating to the patent documents cited in the above-mentioned European search report.
The members are as contained in the European Patent Office EDP file on
The European Patent Office is in no way liable for these particulars which are merely given for the purpose of information.

15-07-2019

| Patent document cited in search report | | Publication date | Patent family member(s) | | Publication date |
|---|---|---|---|---|---|
| US 2016268239 | A1 | 15-09-2016 | CN | 104183606 A | 03-12-2014 |
| | | | US | 2016268239 A1 | 15-09-2016 |
| | | | WO | 2016019646 A1 | 11-02-2016 |
| US 2017358505 | A1 | 14-12-2017 | CN | 107507906 A | 22-12-2017 |
| | | | TW | 201743440 A | 16-12-2017 |
| | | | US | 2017358505 A1 | 14-12-2017 |
| | | | US | 2019043767 A1 | 07-02-2019 |

EPO FORM P0459

For more details about this annex : see Official Journal of the European Patent Office, No. 12/82